# EUROPÄISCHE PATENTANMELDUNG

(11) **EP 3 301 706 A1**
(43) Veröffentlichungstag der Anmeldung: **04.04.2018**
(21) Anmeldenummer: 17172555.9
(22) Anmeldetag: 05.07.2013
(51) Int. Cl.: H01L 21/60, H01L 23/488, H01L 21/66, H01L 21/67

(54) **VERFAHREN ZUM BONDEN VON TEILWEISE METALLISCHEN KONTAKTFLÄCHEN ZWEIER SUBSTRATE MITTELS MEHRERER ÜBEREINANDER AUFGEBRACHTER OPFERSCHICHTEN, BEVORZUGT EINER FESTEN OPFERSCHICHT UND EINER FLÜSSIGEN OPFERSCHICHT**

(62) Teilanmeldung aus: 13734099.8
(71) Anmelder: EV Group E. Thallner GmbH, 4782 St. Florian am Inn (AT)
(72) Erfinder: Rebhan, Bernhard, 4680 Haag am Inn (AT)
(74) Vertreter: Schneider, Sascha

(57) **Zusammenfassung**

Die vorliegende Erfindung betrifft ein Verfahren zum Bonden einer ersten teilweise metallischen Kontaktfläche eines ersten Substrats (1, 1') mit einer zweiten teilweise metallischen Kontaktfläche eines zweiten Substrats mit folgenden Schritten, insbesondere folgendem Ablauf:
- Aufbringen mehrerer ultradünner Opferschichten (4) (vorzugsweise einer festen Opferschicht und einer darauf abgeschiedenen flüssigen Opferschicht, z.B. Wasser) übereinander auf mindestens eine der Kontaktflächen,
- Bonden der Substrate (1, 1'), wobei die Opferschichten (4) während des Bondens im sie umgebenden Material gelöst werden oder am Interface verbraucht werden.

Die Kontaktflächen können aus mehreren Bondbereichen (3') ausgebildet sein, die von Bulkmaterial (5) umgeben oder in Substratkavitäten (2) angeordnet sind.

Die flüssige Opferschicht kann zur Erzeugung eines Pre-Bonds zwischen den Substraten (1, 1') verwendet werden.

## Beschreibung

Die vorliegende Erfindung betrifft ein Verfahren zum Bonden einer ersten Kontaktfläche eines ersten Substrats mit einer zweiten Kontaktfläche eines zweiten Substrats gemäß Anspruch 1.

Seit mehreren Jahren kommt in der Halbleiterindustrie die sogenannte Bonding-Technologie zum Einsatz. Die Bonding-Technologie erlaubt eine Verbindung zweier oder mehrerer, meist sehr präzise zueinander ausgerichteter, Substrate. Diese Verbindung erfolgt in den meisten Fällen permanent, also irreversibel. Irreversibel bedeutet, dass die Trennung der beiden Substrate nach dem Bondvorgang nicht mehr ohne deren Zerstörung oder zumindest deren teilweiser Zerstörung möglich ist. Beim Verbinden der Substrate zeigt sich, dass unterschiedliche chemische und physikalische Mechanismen existieren, die eine permanente Verbindung hervorrufen. Besonders interessant sind nichtmetallische Oberflächen. Bei nichtmetallischen Oberflächen kommt es durch reine Kontaktierung zur Ausbildung eines sogenannten Prebonds.
Diese sich spontan ausbildende, reversible, über Oberflächeneffekte hervorgerufene, Verbindung der beiden Substrate nennt man Prebond, um sie vom späteren, durch eine zusätzliche Wärmebehandlung hervorgerufenen wirklichen, nicht mehr trennbaren, also irreversiblen, eigentlichen Bond zu unterscheiden. Der so erzeugte Prebond zeichnet sich dennoch durch eine nicht zu unterschätzende Festigkeit aus. Obwohl derartig miteinander verbundene Wafer für einen permanenten Bond noch bei höheren Temperaturen wärmebehandelt werden müssen, reicht die Festigkeit des Prebonds bereits aus, um die zwei Substrate bis zum nächsten Prozessschritt zu fixieren. Der Prebond ist ein extrem nützliches Mittel für die Vorfixierung zweier Substrate, vor allem nach einem Ausrichtungsprozess, da sich die beiden Substrate nach dem Ausrichtungsprozess nicht mehr zueinander bewegen dürfen. Der Prebond dürfte hauptsächlich auf Van der Waals Kräften beruhen, die durch permanente und induzierte Dipole an der Oberfläche der Substrate vorhanden sind. Da die Van der Waals Kräfte sehr schwach sind, ist eine entsprechend hohe Kotaktfläche erforderlich, damit es zu einer nennenswerten Haftwirkung zwischen den Substraten kommt. Unpolierte Festkörperoberflächen kontaktieren bei entsprechend hoher Rauigkeit allerdings nicht optimal. Im Fall von reinem Festkörperkontakt entstehen Prebonds daher vorwiegend zwischen sehr ebenen, polierten Substratoberflächen. Bei Raumtemperatur können unter Umständen auch bereits vereinzelte, kovalente Bindungen zwischen den Substratoberflächen entstehen, sogar ohne zusätzliche Temperatur- und/oder Kraftbeaufschlagung der Substrate. Die Anzahl der bei Raumtemperatur gebildeten kovalenten Verbindungen dürfte aber vernachlässigbar gering sein.

Vor allem die Verwendung von Flüssigkeiten könnte eine entsprechende Haftwirkung zwischen Substraten erhöhen. Die Flüssigkeit gleicht einerseits Unebenheiten an den Oberflächen der Substrate aus und bildet selbst, mit Vorzug sogar permanente, Dipole aus. Eine ausgeprägte Prebondfähigkeit stellt man vor allem an nichtmetallischen Oberflächen fest. Halbleiter wie Silizium, Keramiken, hier vor allem Oxide, Metalloxide die poliert und extrem eben sind, zeigen bei Kontaktierung ein entsprechendes Verhalten.

Bei nichtmetallischen Oberflächen, also Oberflächen die einen vorwiegend kovalenten Bindungscharakter aufzeigen, wie beispielsweise Si, SiO₂ etc. kann ein vorher aufgetragener Flüssigkeitsfilm durch während der Wärmebehandlung entstehende kovalente Bindungen sogar zur Verstärkung des permanenten Bonds beitragen. Die nichtmetallischen Oberflächen, werden nach dem Prebond einer Wärmebehandlung unterzogen. Die thermische Aktivierung erzeugt kovalente Bindungen zwischen den Oberflächen und erzeugt so eine irreversible Verbindung. So werden einkristalline, hoch präzise geschnittene und geschliffene Siliziumwafer vor allem durch die Ausbildung kovalenter Verbindungen zwischen den Siliziumatomen miteinander verschweißt. Befindet sich ein Siliziumoxid auf einem Siliziumwafer, kommt es vorwiegend zur Ausbildung von kovalenten Silizium-Oxid- und/oder Oxid-Oxid-Bindungen. Es hat sich gezeigt, dass die Verwendung von sehr dünnen Flüssigkeitsschichten, meistens von Wasser, die Ausbildung der kovalenten Bindungen zwischen den Oberflächen hervorruft oder zumindest verbessert. Die Flüssigkeitsschichten sind dabei nur einige Nanometer dick oder bestehen sogar nur aus einer einzigen Monolage der Flüssigkeit. Die Flüssigkeitsschichten verbessern damit nicht notwendigerweise nur das Prebondverhalten sondern tragen auch entscheidend zur Bildung kovalenter Verbindungen bei. Der Grund liegt, im Fall von Wasser hauptsächlich in der Bereitstellung von Sauerstoff als Verbindungsatom zwischen den Atomen der Substratoberflächen, die miteinander verbondet werden sollen. Die Bindungsenergie zwischen dem Wasserstoff und dem Sauerstoff eines Wassermoleküls ist gering genug um mit der eingebrachten Energie gebrochen zu werden. Als neue Reaktionspartner für den Sauerstoff kommen dann vor allem die Atome der Substratoberflächen in Frage. Man muss allerdings erwähnen, dass es Oberflächen gibt, bei denen derartige Vorgänge, bei denen Atome der Flüssigkeit am permanenten Bondprozess der Substratoberflächen direkt teilnehmen, nicht notwendigerweise vorkommen müssen.

Gänzlich anders verläuft der Bondprozess bei reinen Metalloberflächen. Da sich Metalle durch ihren metallischen Bindungscharakter chemisch und physikalisch vollkommen anders verhalten, bedarf es einer völlig anderen Bondstrategie. Metalle werden vor allem bei höheren Temperaturen und meist unter sehr hohem Druck miteinander verbondet. Die hohen Temperaturen, führen zu einer verstärkten Diffusion entlang der Oberflächen und/oder der Korngrenzen und/oder des Volumens. Durch die erhöhte Mobilität der Atome treten unterschiedliche physikalische und chemische Effekte ein, die zu einer Verschweißung der beiden Oberflächen führen. Der Nachteil bei derartigen Metallbonds besteht also vor allem in der Verwendung sehr hoher Temperaturen und Drücke, um überhaupt eine Verbindung beider Substrate zu gewährleisten. In der überwiegenden Anzahl der Fälle wird man allerdings keine reinen Metalloberflächen vorfinden. Beinahe alle Metalle (mit Ausnahme von sehr inerten Metallen wie Pt, Au und Ag) überziehen sich in der Atmosphäre mit einer, wenn auch nur sehr dünnen, Oxidschicht. Diese Oxidschicht reicht aus, um auch zwischen den mit einer sehr dünnen Oxidschicht bedeckten Metalloberflächen einen Prebond zu erzeugen. Allerdings ist diese Oxidschicht wiederum ungewollt, wenn man vorhat, zwei Metalle direkt miteinander zu verbonden, beispielsweise um zwei leitfähige Kontakte miteinander zu verbinden.

Die Wärmebehandlung der Substrate bedingt entsprechend lange Aufheiz-und Abkühlzeiten. Die hohen Temperaturen können außerdem zu Störungen in funktionalen Einheiten wie beispielsweise Mikrochips und vor allem in Speicherchips führen und diese bis zur Unbrauchbarkeit beschädigen.

Des Weiteren müssen Substrate mit entsprechenden Oberflächen vor dem eigentlichen Bondschritt zueinander ausgerichtet werden. Diese einmal durchgeführte Ausrichtung darf bis zum endgültigen, also permanenten Bondprozess nicht mehr zerstört werden. Vor allem bei höheren Temperaturen kommt es im Allgemeinen allerdings, auf Grund der unterschiedlichen thermischen Ausdehnungskoeffizienten unterschiedlicher Materialien und den daraus resultierenden thermischen Dehnungen, zu einer Verschiebung unterschiedlicher Teilbereiche der Substrate zueinander. Im schlimmsten Fall bestehen die beiden zueinander zu verbindenden Substrate aus zwei unterschiedlichen Materialien mit unterschiedlichen thermischen Ausdehnungskoeffizienten. Diese Verschiebungen sind umso größer, je größer die Differenz der thermischen Ausdehnungskoeffizienten der unterschiedlichen Materialien ist.

Aufgabe der vorliegenden Erfindung ist es, eine möglichst effiziente Methode zum Niedertemperatur- und/oder Niederdruckbonden von Materialien aufzuzeigen.

Die vorliegende Aufgabe wird mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Der Erfindung liegt der Gedanke zugrunde, mindestens eine ultradünne Opferschicht auf mindestens einer der Kontaktflächen der zu bondenden Substraten abzuscheiden, welche während des erfindungsgemäßen Bondschritts im sie umgebenden Material gelöst oder am Interface verbraucht wird. Ein weiterer Aspekt der Erfindung besteht darin, dass das Bonden von Metalloberflächen durch einen vorherigen Benetzungsprozess mit einem Material, insbesondere zumindest überwiegend einer Flüssigkeit, vorzugsweise zumindest überwiegend Wasser, als Opferschicht, insbesondere zur Erzeugung eines Pre-Bonds zwischen den Substraten, verwendet wird. Denkbar ist auch eine Kombination aus mehreren Opferschichten übereinander, mit besonderem Vorzug die Abscheidung einer festen Opferschicht und einer darauf abgeschiedenen flüssigen Opferschicht. Im Allgemeinen können also auch mehrere Opferschichten übereinander aufgebracht werden.

Obwohl die offenbarte Erfindung sich grundsätzlich für alle Materialklassen eignet, welche die notwendigen Voraussetzungen erfüllen, sind vor allem Metalle für die erfindungsgemäße Ausführungsform geeignet. Daher wird in der weiteren Offenbarung die erfindungsgemäße Ausführungsform exemplarisch an Metalloberflächen veranschaulicht.

Das Substrat besteht insbesondere aus Silizium, wobei auf dem Substrat eine, insbesondere metallische, vorzugsweise aus Cu bestehende, Bondschicht zumindest in Bondbereichen aufgebracht ist. Soweit die Bondschicht nicht das gesamte Substrat bedeckt, sind die Bondbereiche vorzugsweise von Bulkmaterial, insbesondere des Substrats, umgeben und bilden gemeinsam die, insbesondere ebene, Kontaktfläche.

Gemäß einem weiteren, insbesondere eigenständigen, Aspekt der vorliegenden Erfindung werden die miteinander zu verbondenden Bondbereiche mit einer Opferschicht beschichtet, die einerseits fähig ist, einen Prebond zu erzeugen, deren Atome andererseits nach dem Prebond bei möglichst geringer Temperaturbehandlung vom/im Material der Bondbereiche gelöst werden. Die Materialschicht besteht dabei mit Vorzug aus einem Material, in welchem zu keinem Zeitpunkt die Löslichkeitsgrenze für das Material der Opferschicht erreicht wird. Erfindungsgemäß löst sich das Material der Opferschicht vollständig in der Materialschicht an mindestens einer der Kontaktflächen, vorzugsweise an beiden Kontaktflächen, auf. Die Konzentration wird mit Vorzug in Atomprozent (at%) angegeben. Erfindungsgemäß liegt die Löslichkeit des Materials der Opferschicht im, insbesondere metallischen, Material mindestens einer der Kontaktflächen zwischen 0 at% und 10 at%, mit Vorzug zwischen 0 at% und 1 at%, mit größerem Vorzug zwischen 0 at% und 0.1 at%, mit größtem Vorzug zwischen 0 at% und 0.01 at%, mit allergrößtem Vorzug zwischen 0 at% und 0.001 at%, am bevorzugtesten zwischen 0 at% und 0.0001 at%..

Die Dicke der Opferschicht ist erfindungsgemäß kleiner als 1000nm, mit Vorzug kleiner als 100nm, mit größerem Vorzug kleiner als 10nm, mit größtem Vorzug kleiner als 1nm. Das Verhältnis der Dicke der Opferschicht zur Dicke der Substrate, insbesondere von Bondbereichen der Substrate, ist kleiner als 1, mit Vorzug kleiner als 10⁻², mit Vorzug kleiner als 10⁻⁴, mit größerem Vorzug kleiner als 10⁻⁶, mit noch größerem Vorzug kleiner als 10⁻⁸.

Die Opferschicht kann durch jedes beliebige Abscheideverfahren auf mindestens eine der Kontaktflächen aufgebracht werden. Bevorzugt sind Abscheideverfahren, die eine möglichst grobkörnige und/oder zumindest überwiegend einkristalline Opferschicht erzeugen. Erfindungsgemäß denkbare Abscheideverfahren sind insbesondere:
- Atomic Layer Deposition,
- Elektrochemische Abscheidung,
- Physical Vapour Deposition (PVD),
- Chemical Vapour Deposition (CVD),
- Dampfphasenabscheidungen durch Kondensation und/oder Resublimation wie beispielsweise die direkte Abscheidung von Wasser aus Wasserdampf auf einer Oberfläche,
- Plasma Abscheidung,
- Naschemische Abscheideverfahren,
- Sputtern und/oder
- Molekularstrahlepitaxie.

Erfindungsgemäß ist es von Vorteil, wenn die Opferschicht, insbesondere Si, in-situ gemeinsam mit der Bondschicht, insbesondere Cu, auf das Substrat aufgebracht wird. Hierdurch wird die Bildung von Oxid auf der Bondschicht vermieden.

Die Opferschicht besteht erfindungsgemäß insbesondere aus einem Material, welches zur Ausbildung eines Pre-bonds geeignet ist und eine Löslichkeit im Bond- und/oder Bulkbereich an den Kontaktflächen mindestens eines der zu kontaktierenden Substrate aufweist. Die Opferschicht besteht insbesondere zumindest teilweise, vorzugsweise überwiegend, aus wenigstens einem der folgenden Materialen bzw. Stoffe:
- Metalle, insbesondere
   ∘ Cu, Ag, Au, Al, Fe, Ni, Co, Pt, W, Cr, Pb, Ti, Te, Sn und/oder Zn,
- Legierungen,
- Halbleiter (mit entsprechender Dotierung), insbesondere
   ∘ Elementhalbleiter, vorzugsweise
      ▪ Si, Ge, Se, Te, B und/oder α-Sn,
   ∘ Verbindungshalbleiter, vorzugsweise
      ▪ GaAs, GaN, InP, InₓGa₁₋ₓ,N,InSb, InAs, GaSb, AIN, InN, GaP, BeTe, ZnO, CuInGaSe₂, ZnS, ZnSe, ZnTe, CdS, CdSe, CdTe, Hg(1-x)Cd(x)Te, BeSe, HgS, AlₓGa₁₋ₓAs, GaS, GaSe, GaTe, InS, InSe, InTe, CuInSe₂, CuInS₂, CuInGaS₂, SiC und/oder SiGe,
   ∘ Organische Hlableiter, vorzugsweise
      ▪ Flavanthron, Perinon, Alq3, Perinon, Tetracen, Chinacridon, Pentacen, Phthalocyanine, Polythiophene, PTCDA, MePTCDI, Acridon und/oder Indanthron,
- Flüssigkeiten, insbesondere
   ∘ Wasser,
   ∘ Alkohole,
   ∘ Aldehyde,
   ∘ Ketone,
   ∘ Ether,
   ∘ Säuren,
   ∘ Basen.

In einer ersten erfindungsgemäßen Ausführungsform handelt es sich bei dem Bondbereich um eine sich über die gesamte Kontaktfläche des Substrats erstreckende Schicht. Die Rauigkeit der Oberfläche des Bondbereichs wird insbesondere durch bekannte Verfahren reduziert. Mit Vorzug wird ein chemisch-mechanischer Polierprozess (CMP) verwendet. Danach wird die gesamte Bondbereichsoberfläche mit der erfindungsgemäßen Opferschicht bedeckt. Die Opferschicht wird derart aufgebracht oder nach der Aufbringung behandelt, dass die mittleren Rauhigkeitswerte kleiner als 1 µm, mit Vorzug kleiner als 500nm, mit größerem Vorzug kleiner als 100nm, mit noch größerem Vorzug kleiner als 10nm, mit größtem Vorzug kleiner als 1nm, sind.

In einer zweiten erfindungsgemäßen Ausführungsform sind mehrere, über die gesamte Kontaktfläche verteilte Bondbereiche vorgesehen. Die Bondbereiche bilden insbesondere eine die Kontaktfläche mindestens eines der Substrate überragende Topographie, ragen also über dessen Oberfläche hinaus. Die Bondbereiche werden vorzugsweise von einem beliebigen Bulkmaterial umgeben. Die Oberflächen des Bulkmaterials und die Bondbereichsoberfläche bilden insbesondere eine gemeinsame Ebene E. Die aus leitenden Bereichen bestehenden, von nichtleitenden Bereichen umgebenen, Oberflächen sind auch unter dem Namen Hybridoberflächen bekannt. Die nichtleitenden Bereiche bestehen aus einem Dielektrikum und isolieren die leitenden Bereiche. Die denkbar einfachste Ausführungsform wären durch Dielektrika isolierte Kontaktstellen für den Ladungstransport. Durch das Bonden dieser Hybridoberflächen kann eine leitende Verbindung zwischen den Substraten über die verbondeten Kontaktstellen erreicht werden.

Die Opferschicht wird erfindungsgemäß vollflächig auf den Kontaktflächen, also sowohl auf der Bulkmaterialoberfläche als auch den Bondbereichsoberflächen abgeschieden. Bei den lokalen Bondbereichen handelt es sich insbesondere um Kupferstecker (engl.: Cu pads), Metallverbindungen (engl.: metal joints) oder Metallrahmen für das Packaging. Cu pads dienen insbesondere der elektrischen Verbindung zwischen funktionalen Einheiten in den unterschiedlichen Schichtsystemen. Metal joints könnten insbesondere Siliziumdurchkontakte (engl.: through silicon vias, TSVs) sein. Bei einem Metallrahmen kann es sich beispielsweise um eine Mikroverpackung für ein MEMS Device handeln. Diese funktionellen Einheiten wurden in den Zeichnungen der Übersicht halber nicht dargestellt.

In einer dritten erfindungsgemäßen Ausführungsform sind mehrere über die gesamte Kontaktfläche verteilte Bondbereiche unmittelbar innerhalb des Substrats vorgesehen, wobei das Substrat zuerst durch Ätztechniken strukturiert und danach mit dem entsprechenden Bondbereichsmaterial aufgefüllt und anschließend vom Opfermaterial bedeckt wird.

In einem erfindungsgemäßen Bondschritt werden die zwei als beliebige Schichtsysteme ausgebildeten Substrate einander angenähert, sodass die, auf den Kontaktflächen aufgebrachten Opferschicht(en) einander berühren und einen Prebond bilden. Die Rauigkeiten der Opferschichtoberflächen können durch chemische und/oder mechanische Verfahren weitgehend reduziert, vorzugsweise beseitigt werden. Bei bestimmten Schichtsystemen kann eine Ausrichtung der Schichtsysteme zueinander in einer Ausrichtungseinheit (engl.: aligner) vor dem prebond erfolgen.

Vor dem Prebonden können die Opferschichtoberflächen erfindungsgemäß mit einer Flüssigkeit, mit Vorzug Wasser, benetzt werden. Mit Vorzug ist die aufgetragene Flüssigkeitsschicht dünner als 100nm, mit größerem Vorzug dünner als 10nm, mit größtem Vorzug dünner als 1nm, mit allergrößtem Vorzug nur eine Monolage. Bei hydrophilen Oberflächen ist es ausreichend, das Substrat der Umgebungsatmosphäre auszusetzen. Die Oberfläche wird dann durch den Wasserdampf aus der Atmosphäre benetzt.

Die Flüssigkeit kann erfindungsgemäß insbesondere durch Kondensation aufgebracht werden. In einer besonderen Ausführungsform wird das zu beschichtende Substrat, mit Vorzug in gekühltem Zustand, in einen aufgeheizten Raum mit dampfgesättigter Atmosphäre eingebracht. Durch die geringe Temperatur des Substrats kondensiert die Flüssigkeit schlagartig an dessen Oberfläche.

In einer alternativen Ausführung der Erfindung wird das Material der Opferschicht, insbesondere als Flüssigkeit, durch einen Schleuderbelackungsprozess aufgebracht.

In einer weiteren alternativen Ausführung der Erfindung wird das Material der Opferschicht, insbesondere als Flüssigkeit, durch eine Sprühbelackungsanlage auf die Kontaktfläche mindestens eines der Substrate gesprüht.

In besonderen Ausführungsformen wird das Wasser durch einen Dampfdrucksättiger (engl.: Bubbler) in die Reaktionskammer eingeführt, in der sich das Substrat befindet. Dazu werden Inertgase wie beispielsweise Argon, Helium, Stickstoff durch ein Wasserbad getrieben. Das Inertgas unterstützt das Wasser beim Verdampfen und sättigt die Reaktionskammer mit Wasserdampf. Das Wasser kondensiert an der Oberfläche des Substrats und bildet einen sehr dünnen Wasserfilm. Durch Kühlung des Substrats kann die Kondensation des Wassers unterstützt werden.

In einer weiteren besonderen Ausführungsform wird das Wasser in einem einfachen Verdampfer verdampft und auf die Oberfläche des Substrats geleitet. Im Gegensatz zum Bubbler wird hier nicht notwendigerweise mit einem Inertgas gearbeitet, sondern die Temperatur des Wassers wird möglichst nahe an den Siedepunkt gebracht um die kinetische Energie des Wassers zu erhöhen und damit die Verdampfung zu beschleunigen. Durch eine Evakuierung der Reaktionskammer kann der Siedepunkt entsprechend gesenkt und der Vorgang damit optimiert werden.

Aus der Überlegung, dass spezielle Reaktionskammern gebaut werden können, die die erfindungsgemäßen Opferschichten präzise abscheiden können ergibt sich dementsprechend auch eine erfindungsgemäße Anlage, im weiteren Verlauf der Patentschrift als Reaktionskammer bezeichnet.

Der Prebond wird mit Vorzug in einem Kontaktpunkt der Kontaktflächen initiiert und breitet sich durch eine Bondwelle über die gesamte Oberfläche aus. Der Kontakt beider Opferschichtoberflächen kann dabei insbesondere durch einen Pin hergestellt werden, der eines der beiden Substrate verbiegt, sodass sich die Kontaktfläche dieses Substrats konvex verformt und mit der Opferschichtoberfläche des zweiten, insbesondere plan auf einer Aufnahmefläche aufliegenden Substrats, in Kontakt gebracht wird.

Nach der Ausbildung des Prebonds werden die beiden gebondeten Substrate wärmebehandelt. Die Wärmebehandlung erfolgt bei möglichst niedrigen Temperaturen, im Idealfall bei Raumtemperatur. Die Temperatur ist dabei kleiner als 500°C, mit Vorzug kleiner als 400°C, bevorzugter kleiner als 300°C, noch bevorzugter kleiner als 200°C, am bevorzugtesten kleiner als 100°C, am allerbevorzugtesten kleiner als 50°C.

Durch eine erfindungsgemäß sehr dünne Ausführung der Opferschicht wird eine schnelle Diffusion von Atomen der Opferschicht, insbesondere ausschließlich, in den Bondbereichen ermöglicht. Die erfindungsgemäße Diffusion wird durch eine Wärmebehandlung beschleunigt und/oder begünstigt. Mit Vorzug lösen sich die Atome der Opferschicht erfindungsgemäß vollständig im Material des Bondbereichs und/oder des Bulkmaterials auf. Erfindungsgemäß denkbar ist auch ein Vorgang, bei dem die Atome der Bondbereiche sich in der Opferschicht lösen, was auf Grund der extrem geringen Dicke der Opferschicht technisch gesehen identisch mit der oben beschriebenen Ausführung ist.

Mit Vorzug werden die Substrate während des erfindungsgemäßen Diffusionsvorganges der Atome der Opferschicht in die Bondbereiche mit Druck beaufschlagt. Der Druck auf die Oberfläche liegt insbesondere zwischen 0,01MPa und 10MPa, mit Vorzug zwischen 0,1MPa und 8MPa, mit größerem Vorzug zwischen 1MPa und 5MPa, mit größtem Vorzug zwischen 1,5MPa und 3MPa. Diese Werte entsprechen etwa einer Kraftbeaufschlagung von 1kN bis 320kN für ein 200mm-Substrat.

Die Oberfläche der Opferschicht sollte vor dem erfindungsgemäßen Prebondvorgang frei von Kontaminationen und/oder zumindest überwiegend, vorzugsweise vollständig, frei von Oxiden sein. Insbesondere kann es auch nötig sein, das Material, auf dem die Opferschicht aufgebracht wird, von Oxid zu befreien, bevor die Opferschicht aufgebracht wird. Vor einem erfindungsgemäßen Prebondvorgang wird daher vorzugsweise eine Reinigung der Opferschichtoberfläche vorgenommen. Die Entfernung von Oxiden kann durch dem Fachmann bekannte physikalische und/oder chemische Methoden erfolgen. Dazu zählen chemische Reduktion durch Gase und/oder Flüssigkeiten mit entsprechendem Abtransport der Abfallprodukte, mechanisches Abtragen der Oxide durch Sputtern und/oder Plasma und/oder CMP und/oder einer oder mehrere der nachfolgenden Methoden:
- Chemische Oxidentfernung, insbesondere
   ∘ Gasförmiges Reduktionsmittel,
   ∘ Flüssiges Reduktionsmittel,
- Physikalische Oxidentfernung, insbesondere
   ∘ Plasma,
   ∘ Ion Assisted Chemical Etching,
   ∘ Fast Ion Bombardement (FAB, Sputtern),
   ∘ Schleifen,
   ∘ Polieren.

Unter einer chemischen Oxidentfernung versteht man die Entfernung des Oxids durch einen chemischen Vorgang. Unter einem chemischen Vorgang versteht man eine Stoffumwandlung. In diesem Fall wird das Oxid durch ein Reduktionsmittel in gasförmiger und/oder flüssiger Phase reduziert und das Reduktionsmittel entsprechend zur neuen Verbindung oxidiert. Das oxidierte Reduktionsmittel, also das Reaktionsprodukt wird entsprechend abgeführt. Eines typisches Reduktionsmittel ist beispielsweise Wasserstoff.

Unter physikalischer Oxidentfernung versteht man die Entfernung des Oxids durch einen physikalischen Prozess. Bei einem physikalischen Prozess kommt es nicht zu einer Stoffumwandlung sondern zu einer rein mechanischen Entfernung des Oxids von der Oberfläche des Substrats. Die am häufigsten verwendete physikalische Reduktionstechnologie ist die Plasmatechnologie. Dabei wird ein Plasma erzeugt, welches durch entsprechende Felder auf die Oberfläche des Substrats beschleunigt wird und eine entsprechende physikalische Oxidentfernung bewerkstelligt. Denkbar ist auch die Verwendung einer Sputtertechnologie. Im Gegensatz zum Plasma wird dabei nicht ein statistisches Vielteilchensystem in der Reaktionskammer erzeugt, sondern man erzeugt Ionen in einer Vorkammer und beschleunigt diese gezielt auf ein Substrat. Schließlich wären noch das Schleifen und das Polieren als Oxidentfernungsprozesse zu nennen. Durch ein Schleif- bzw. Polierwerkzeug wird das Oxid schrittweise entfernt. Schleifen und Polieren eignet sich vor allem als Vorbehandlungsprozess wenn man es mit sehr dicken Oxidschichten im Mikrometerbereich zu tun hat. Für die korrekte Entfernung von Oxidschichten im Nanometerbereich sind diese Methoden weniger geeignet.

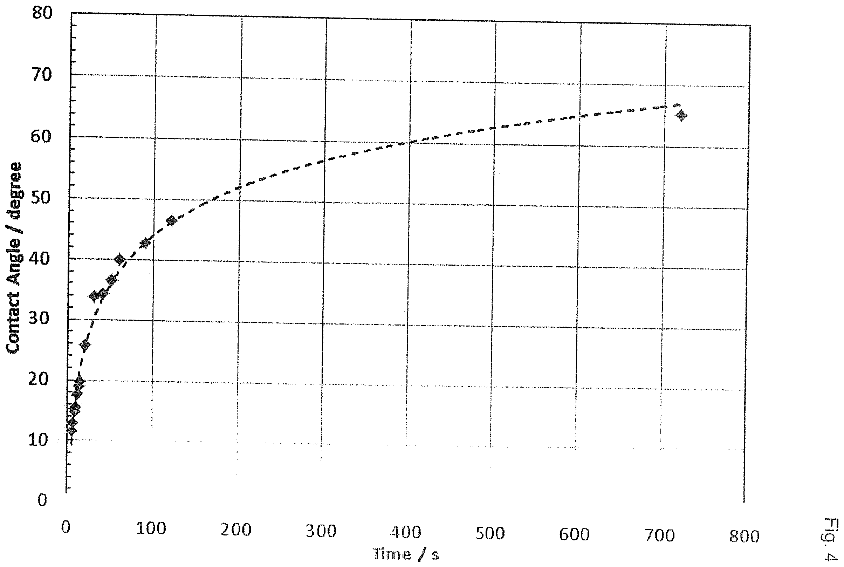

Ein Nachweis der Oberflächenreinheit kann sehr schnell und einfach mit der Kontaktwinkelmethode durchgeführt werden. Es ist bekannt, dass nicht oxidische Oberflächen, vor allem reines Kupfer, eher hydrophile Eigenschaften besitzen. Das zeigt sich vor allem durch einen sehr kleinen Kontaktwinkel. Oxidiert die Oberfläche zum Oxid, im Speziellen Kupfer zu Kupferoxid, werden die Oberflächeneigenschaften immer hydrophober. Ein gemessener Kontaktwinkel ist entsprechend groß. Um die Änderung des Kontaktwinkels als Funktion der Zeit, und damit als Funktion fortschreiten der Kupferoxid-Dicke, darzustellen, wurde der Kontaktwinkel eines Wassertropfens nach definierten Zeiteinheiten, ausgehend vom Zeitpunkt der völligen Oxidentfernung des nativen Kupferoxids, gemessen. Der Kontaktwinkel nähert sich mit zunehmender Zeit einem Sättigungswert. Dieser Zusammenhang könnte mit der Änderung der Elektronenstruktur der Oberfläche durch das rasch wachsende Kupferoxid erklärt werden. Ab einer gewissen Kupferoxidschichtdicke trägt eine weitere Vermehrung des Oxids nicht mehr maßgeblich zur Änderung der Elektronenstruktur der Oberfläche bei, was sich in einem logarithmischen Abklingen des Kontaktwinkels wiederspiegelt (siehe Figur 4).

Die so entstehenden Oxide werden bevorzugt vor der Beschichtung der Bondbereichoberflächen und/oder Bulkmaterialoberflächen mit den Opferschichtoberflächen und/oder vor dem Bonden der Opferschichtoberflächen miteinander entfernt. Die hier genannte Kontaktwinkelmethode dient dabei der schnellen, präzisen und kosteneffizienten Evaluierung des Oxidzustandes. Sie kommt ohne komplizierte chemische und/oder physikalische Analyseapparate aus. Kontaktwinkelmessgeräte können in entsprechende Modulgruppen der Vorrichtung zur vollautomatischen Messung und Charakterisierung der Oberflächen eingebaut werden. Alternative Messmethoden wären die Ellipsometrie oder jedes andere bekannte optische und/oder elektrische Verfahren.

In einer weiteren erfindungsgemäßen Ausführungsform wird ein Bondvorgang zwischen den Bondbereichsoberflächen mit Wasser als Opferschicht durchgeführt. Der erfindungsgemäße Gedanke besteht darin, die Bondbereichsoberflächen vollständig von Oxid zu reinigen und in einem anschließenden, direkt auf die Oxidentfernung folgenden Schritt, eine Benetzung der Bondbereichsoberflächen mit Wasser durchzuführen, welches einen Prebond zwischen den Bondbereichsoberflächen bei Raumtemperatur erlaubt. Die Benetzung erfolgt dabei durch eine der bereits erwähnten Möglichkeiten wie PVD, CVD, Schleuderbelackung, Dampfphasenabscheidung oder dem Aussetzen der Substratoberfläche in einer Atmosphäre die eine genügend hohe Luftfeuchtigkeit besitzt, mit Vorzug sogar an Wasserdampf gesättigt ist.

Die Aufbringung der Opferschichten erfolgt in einer Reaktionskammer. Mit Vorzug kann die Reaktionskammer evakuiert werden. Die, insbesondere kontinuierliche, Evakuierung der Reaktionskammer ist des Weiteren von Vorteil, um eine gezielte Einstellung der Atmosphäre zu ermöglichen. Mit Vorzug ist die Reaktionskammer Teil eines Moduls eines Vakuumelusters, mit Vorzug Teil eines Niedervakuumcluster, mit größerem Vorzug eines Hochvakuumclusters, mit größtem Vorzug Teil eines Ultrahochvakuumclusters. Der Druck in der Reaktionskammer beträgt weniger als 1 bar, mit Vorzug weniger als 10⁻¹ mbar, mit größerem Vorzug weniger als 10⁻³ mbar, mit größtem Vorzug weniger als 10⁻⁵ mbar, mit allergrößtem Vorzug weniger als 10⁻⁸ mbar.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Fig.1: eine Seitenansicht einer erfindungsgemäßen ersten Ausführungsform mit vollflächigem Bondbereich,
- Fig.2: eine Seitenansicht einer erfindungsgemäßen zweiten Ausführungsform mit mehreren, lokalen Bondbereichen,
- Fig.3: eine Seitenansicht einer erfindungsgemäßen dritten Ausführungsform mit mehreren, lokalen Bondbereichen im Substrat,
- Fig.4: empirische Messdaten des Kontaktwinkels (engl.: contact angle) zwischen der Flüssigkeitstropfenkante und der Oberfläche von Kupfer/Kupferoxid, als Funktion der Zeit (engl.: time) und

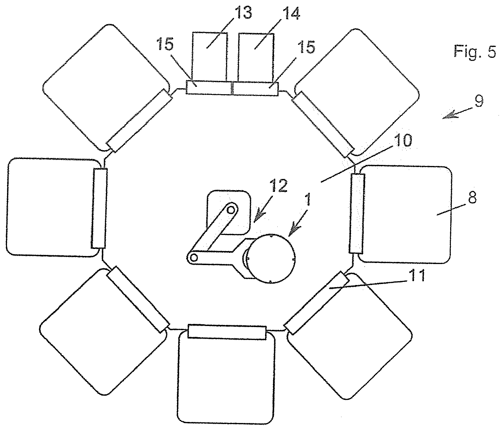

- Fig. 5: eine schematische Aufsicht auf ein die Vorrichtung enthaltendes Clustersystem.

In den Figuren sind gleiche oder gleichwirkende Bauteile mit den gleichen Bezugszeichen gekennzeichnet. Die Zeichnungen zeigen nur schematisch die erfindungsgemäßen Ausführungsformen und sind nicht maßstabsgetreu. So sind vor allem die relativen Dicken der Opferschicht, der Bondbereiche und der Substrate unverhältnismäßig zueinander, genauso wie das Verhältnis der genannten Dicken zum Durchmesser der Substrate.

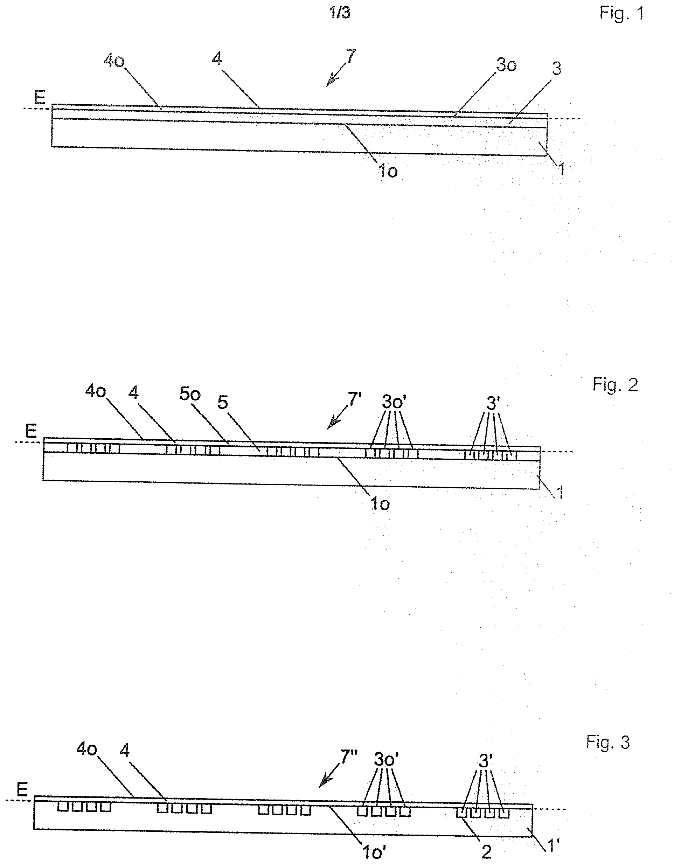

Figur 1 zeigt ein Schichtsystem 7, bestehend aus einem ersten Substrat 1 mit einer Grenzfläche 10, einem Bondbereich 3 mit einer Bondbereichsoberfläche 30, sowie die Opferschicht 4 mit der Opferschichtoberfläche 40. Der Bondbereich 3 erstreckt sich bei der ersten Ausführungsform über die gesamte Grenzfläche 10 des Substrats 1. Die Bondbereichsoberfläche 30 bildet in diesem Fall eine erste Kontaktfläche des ersten Substrats 1. Der Bondbereich 3 kann, insbesondere materialeinstückiger (also aus demselben Material bestehender) und/oder monotlithischer, Bestandteil des ersten Substrats 1 sein. Die Opferschicht 4 ist auf der ersten Kontaktfläche vollflächig aufgebracht.

Figur 2 zeigt ein Schichtsystem 7', bei dem mehrere, vorzugsweise regelmäßig über die Grenzfläche 10 verteilte Bondbereiche 3' mit entsprechenden Bondbereichsoberflächen 30' auf dem ersten Substrat aufgebracht sind. Die Bondbereiche 3' bilden somit eine Topographie über der Oberfläche 10 des Substrats 1. In der gezeigten, bevorzugten Ausführungsform werden die Bondbereiche 3' von einem Bulkmaterial 5 umgeben. Das Bulkmaterial kann ein beliebiges Metall, Nichtmetall, eine Keramik oder ein Polymer, wie beispielsweise ein Resist sein. Mit Vorzug wird es sich allerdings um eine Keramik handeln, insbesondere Si₃N₄ oder SiₓOₓNₓ, mit noch größerem Vorzug um eine Oxidkeramik, insbesondere um SiO₂. Die Bondbereichsoberflächen 3' und die Bulkmaterialoberflächen 50 bilden eine gemeinsame Ebene E, nämlich die erste Kontaktfläche. Die Ebenheit der Bondbereichsoberflächen 3' und der Bulkmaterialoberflächen 50 sowie deren Koplanarität erlauben eine optimale Abscheidung der Opferschicht 4 auf der ersten Kontaktfläche.

Figur 3 zeigt ein Schichtsystem 7", bestehend aus einem strukturierten ersten Substrat 1' mit einer Grenzfläche 10 und mehreren, vorzugsweise regelmäßig im Substrat 1' verteilten Bondbereichen 3' mit Bondbereichsoberflächen 30'. Das Substrat 1 ist durch Ätzen strukturiert worden, sodass sich im Substrat 1' Kavitäten 2 geformt haben. Die so entstandenen Kavitäten 2 werden mit dem Material für die Bondbereiche 3' aufgefüllt, insbesondere mit einem PVD oder CVD Prozess. Das über die gemeinsame Ebene E abgeschiedene Material der Bondbereiche 3' wird anschließend durch einen Rückdünnprozess entfernt. Denkbar wäre die Entfernung bis auf die Ebene E durch Schleifprozesse, Polierprozesse, Chemisch-Mechanisches Polieren etc. Das so hergestellte Substrat 1' mit den Kavitäten 2, die durch das Auffüllen mit Material die Bondbereiche 3' und somit gemeinsam die Kontaktfläche bilden, wird anschließend erfindungsgemäß an dieser mit der Opferschicht 4 bedeckt.

Die Abscheidung der Opferschichten 4 kann für alle erfindungsgemäßen Ausführungsformen so erfolgen, dass Material für die Opferschicht 4 solange abgeschieden wird, bis die nötige Schichtdicke erreicht wird. Die zweite Methode besteht darin, in einem ersten Schritt die Opferschicht 4 dicker auszubilden als erwünscht und sie in einem zweiten Schritt, einem Rückdünnprozess, auf die gewünschte Dicke zu reduzieren. Denkbar wären auch in diesem Fall die Anwendung von Schleifprozessen und/oder Polierprozessen und/oder Chemisch-Mechanischem Polieren. Im Falle flüssiger Opferschichten kann die erforderliche Schichtdicke auch kontinuierlich aufgebaut werden, indem man die Opferschicht wachsen lässt. So weiß man beispielsweise, welche Gleichgewichtsschichtdicke an der Oberfläche eines Substrats entsteht, wenn eine Atmosphäre mit entsprechender Luftfeuchtigkeit erzeugt wird. Durch die gezielte Steuerung von Temperatur, Druck, und Feuchtigkeit, kann man eine wohldefinierte Schichtdicke an der Substratoberfläche erzeugen.

Nachdem zwei Schichtsysteme 7, 7',7" hergestellt sind, werden diese bei niedrigen Temperaturen und/oder mit niedrigen Drücken an den Bondbereichen unter Ausbildung eines Prebond miteinander gebondet.

Vor dem Prebonden können die Opferschichtoberflächen 40 mit einer Flüssigkeit, mit Vorzug Wasser, zusätzlich benetzt werden. Mit Vorzug sind die aufgetragenen Wasserschichten dünner als 100nm, mit größerem Vorzug dünner als 10nm, mit größtem Vorzug dünner als 1nm, mit allergrößtem Vorzug nur eine Monolage. Beispielsweise wäre die Verwendung eines Zweischichtsystems, bestehend aus einer SiO₂-Schicht und einer darauf befindlichen Wasserschicht, denkbar. Die SiO₂-Schicht ist beispielsweise ca. 1.5 nm dick, die Wasserschicht auf der SiO₂-Schicht entsteht alleine durch die Kondensation der Wassermoleküle in der Atmosphäre.

Während und/oder vor dem Annäherungsprozess können die beiden Substrate 7, 7', 7" über Ausrichtungsmarken und/oder andere Ausrichtungsmerkmale entlang der Ebene E in x- und/oder y-Richtung ausgerichtet werden. Der Kontakt der beiden Opferschichten 4 zueinander erfolgt mit Vorzug an einem Punkt, indem eines der beiden Substrate 1,1' durch einen Pin konvex geformt wird. Nach der Kontaktierung der beiden Opferschichtoberflächen 40 entsteht eine Bondwelle, die beide Opferschichtoberflächen durch einen Prebond fest miteinander verbindet.

In einem weiteren erfindungsgemäßen Verfahrensschritt wird eine Wärmebehandlung und/oder ein Bondschritt bei niedrigen Temperaturen durchgeführt. Die erhöhte Temperatur und/oder die Krafteinwirkung führt zu einer Diffusion der Atome der Opferschichten 4 in die Bondbereiche 3, 3'. Die Atome der Opferschichten 4 werden mit Vorzug vollständig in den Bondbereichen 3, 3' und/oder dem sie umgebenden Bulkmaterial 5 gelöst und führen somit zu einem erfindungsgemäßen Direktbond der Bondbereichsmaterialien bei möglichst niedrigen Temperaturen. Der Direktbond kann beispielsweise durch eines der Verfahren in der Patentschrift EP2372755 oder der Patentschrift PCT/EP2012/069268 erfolgen, auf die insofern Bezug genommen wird.

Das erfindungsgemäße Ausführungsform zur Erzeugung der Opferschichten ist mit Vorzug Teil eines Moduls 8 (Opferschichtenmodul) eines Clusters 9, insbesondere eines Niedervakuum-, mit Vorzug eines Hochvakuum-, mit größtem Vorzug eines Ultrahochvakuumclusters. Der Cluster 9 besteht aus einem evakuierbaren Innenraum 10, der hermetisch zu allen vorhandenen Modulen über Modulschleusentore 11 abtrennbar ist. Innerhalb des Innenraums 10 transportiert ein Roboter 12 den Produktwafer 1 von Modul zu Modul. Die Produktwafer 1 gelangen dabei über eine Clusterschleuse 15 eines Eingangs FOUP 13 für die einkommenden Produktwafer 1 in den Innenraum 10. Nach einer erfolgreichen Prozessierung des Produktwafers 1 innerhalb des Clusters 9, legt der Roboter 12 den Produktwafer 1 wieder über eine FOUP Schleuse 15 in einem Ausgangs FOUP 14 ab.

### Bezugszeichenliste

- 1, 1': Substrat
- 10, 10': Grenzfläche
- 2: Kavitäten
- 3, 3': Bondbereich
- 30, 30': Bondbereichsoberfläche
- 4: Opferschicht
- 40: Opferschichtoberfläche
- 5: Bulkmaterial
- 50: Bulkmaterialoberfläche
- 7, 7', 7": Schichtsysteme
- 8: Modul
- 9: Cluster
- 10: Innenraum
- 11: Modulschleusentor
- 12: Roboter
- 13: Eingangs FOUP
- 14: Ausgangs FOUP
- 15: Clusterschleusentor

## Patentansprüche

1. Verfahren zum Bonden einer ersten teilweise metallischen Kontaktfläche eines ersten Substrats (1, 1') mit einer zweiten teilweise metallischen Kontaktfläche eines zweiten Substrats mit folgenden Schritten, insbesondere folgendem Ablauf:
- Aufbringen mehrerer Opferschichten übereinander auf mindestens eine der Kontaktflächen,
- Bonden der Substrate (1, 1'), wobei die Opferschichten während des Bondens im sie umgebenden Material gelöst werden oder an einem Bondinterface verbraucht werden.

2. Verfahren gemäß Anspruch 1, bei dem mindestens eine Opferschicht (4) mit einer Dicke von kleiner als 1000nm, mit Vorzug kleiner als 100nm, mit größerem Vorzug kleiner als 10nm, mit größtem Vorzug kleiner als 1nm, aufgebracht wird.

3. Verfahren nach einem der vorhergehenden Ansprüche, bei dem mindestens eine Opferschicht zumindest überwiegend, insbesondere vollständig aus mindestens einem der nachfolgenden Materialien besteht:
• Metalle, insbesondere
∘ Cu, Ag, Au, Al, Fe, Ni, Co, Pt, W, Cr, Pb, Ti, Te, Sn und/oder Zn,
• Legierungen,
• Halbleiter (mit entsprechender Dotierung), insbesondere
∘ Elementhalbleiter, vorzugsweise
▪ Si, Ge, Se, Te, B und/oder α-Sn,
∘ Verbindungshalbleiter, vorzugsweise
▪ GaAs, GaN, InP, InₓGa₁₋ₓ,N,InSb, InAs, GaSb, AlN, InN, GaP, BeTe, ZnO, CuInGaSe₂, ZnS, ZnSe, ZnTe, CdS, CdSe, CdTe, Hg(1-x)Cd(x)Te, BeSe, HgS, AlₓGa₁₋ₓAs, GaS, GaSe, GaTe, InS, InSe, InTe, CuInSe₂, CuInS₂, CuInGaS₂, SiC und/oder SiGe,
∘ Organische Hlableiter, vorzugsweise
▪ Flavanthron, Perinon, Alq3, Perinon, Tetracen, Chinacridon, Pentacen, Phthalocyanine, Polythiophene, PTCDA, MePTCDI, Acridon und/oder Indanthron,
• Flüssigkeiten, insbesondere
∘ Wasser,
∘ Alkohole,
∘ Aldehyde,
∘ Ketone,
∘ Ether,
∘ Säuren,
∘ Basen.

4. Verfahren nach einem der vorhergehenden Ansprüche, bei dem das Verhältnis der Dicke mindestens einer Opferschicht (4) zur Dicke der Substrate (1, 1'), insbesondere von Bondbereichen (3, 3') der Substrate (1,1'), kleiner als 1, mit Vorzug kleiner als 10⁻², mit Vorzug kleiner als 10⁻⁴, mit größerem Vorzug kleiner als 10⁻⁶, mit noch größerem Vorzug kleiner als 10⁻⁸, ist.

5. Verfahren nach einem der vorhergehenden Ansprüche, bei dem mindestens eine der Kontaktflächen aus mehreren Bondbereichen (3, 3') und die Bondbereiche (3, 3') umgebenden Bulkmaterial (5) ausgebildet ist.

6. Verfahren nach einem der vorhergehenden Ansprüche, bei dem mindestens eine der Kontaktflächen vollflächig an einem Bondbereich (3) angeordnet ist.

7. Verfahren nach einem der vorhergehenden Ansprüche, bei dem eine feste Opferschicht, insbesondere aus Si oder SiO2, auf mindestens eine der Kontaktflächen abgeschieden wird und auf die feste Opferschicht eine flüssige Opferschicht, insbesondere aus Wasser, abgeschieden wird, wobei die aufgetragene Flüssigkeitsschicht vorzugsweise dünner als 100nm, mit größerem Vorzug dünner als 10nm, mit größtem Vorzug dünner als 1nm, mit allergrößtem Vorzug nur eine Monolage ist.

8. Verfahren nach einem der vorhergehenden Ansprüche, bei dem auf mindestens eines der Substrate, insbesondere ein Substrat aus Silizium, eine metallische, vorzugsweise aus Cu bestehende, Bondschicht in Bondbereichen aufgebracht ist, wobei die Bondbereiche vorzugsweise von Bulkmaterial, insbesondere des Substrats, umgeben sind und die Bondbereiche und das Bulkmaterial gemeinsam mindestens eine der, insbesondere ebenen, Kontaktfläche bilden.

9. Verfahren nach einem der vorhergehenden Ansprüche, bei dem mindestens eine der Opferschichten einerseits fähig ist, einen Prebond zu erzeugen, deren Atome andererseits nach dem Prebond bei möglichst geringer Temperaturbehandlung vom/im Material von Bondbereichen gelöst werden.

10. Verfahren nach einem der vorhergehenden Ansprüche, bei dem eine Materialschicht von Bondbereichen aus einem Material besteht, in welchem zu keinem Zeitpunkt die Löslichkeitsgrenze für das Material mindestens einer der Opferschichten erreicht wird, wobei sich das Material der mindestens einen Opferschicht vollständig in der Materialschicht an mindestens einer der Kontaktflächen, vorzugsweise an beiden Kontaktflächen, auflöst.

11. Verfahren nach einem der vorhergehenden Ansprüche, bei dem mindestens eine Opferschicht durch eines der folgenden Abscheideverfahren aufgebracht wird:
• Atomic Layer Deposition,
• Elektrochemische Abscheidung,
• Physical Vapour Deposition (PVD),
• Chemical Vapour Deposition (CVD),
• Dampfphasenabscheidungen durch Kondensation und/oder Resublimation wie beispielsweise die direkte Abscheidung von Wasser aus Wasserdampf auf einer Oberfläche,
• Plasma Abscheidung,
• Naschemische Abscheideverfahren,
• Sputtern und/oder
• Molekularstrahlepitaxie.

12. Verfahren nach einem der vorhergehenden Ansprüche, bei dem mindestens eine Opferschicht, insbesondere Si, in-situ gemeinsam mit einer Bondschicht, insbesondere Cu, auf mindestens eines der Substrate aufgebracht wird.

13. Verfahren nach einem der vorhergehenden Ansprüche, bei dem mehrere, über die gesamte Kontaktfläche, verteilte Bondbereiche vorgesehen sind, wobei die Bondbereiche insbesondere eine die Kontaktfläche mindestens eines der Substrate überragende Topographie bilden.

14. Verfahren nach einem der vorhergehenden Ansprüche, bei dem die Kontaktflächen aus leitenden und nichtleitenden Bereichen bestehen.

15. Verfahren nach einem der vorhergehenden Ansprüche, bei dem mindestens eine Opferschichte vollflächig auf den Kontaktflächen abgeschieden werden, insbesondere sowohl auf einer Bulkmaterialoberfläche als auch auf Bondbereichsoberflächen.

16. Verfahren nach einem der vorhergehenden Ansprüche, bei dem die Substrate einander angenähert werden und sich die auf den Kontaktflächen aufgebrachten Opferschichten einander berühren und einen Prebond bilden.
